Europäisches Patentamt

(19) European Patent Office

Office européen des brevets

(11) EP 0 917 003 A1

(12) EUROPEAN PATENT APPLICATION

(43) Date of publication:
19.05.1999 Bulletin 1999/20

(51) Int. Cl.$^6$: G03F 7/12, B41C 1/14

(21) Application number: 97402735.1

(22) Date of filing: 14.11.1997

(84) Designated Contracting States:
AT BE CH DE DK ES FI FR GB GR IE IT LI LU MC
NL PT SE
Designated Extension States:
AL LT LV MK RO SI

(71) Applicant:
KOREA INSTITUTE OF MACHINERY &
MATERIALS
Daejeon-si (KR)

(72) Inventors:
• Han, You Hie
Youseong-gu, Daejeon-shi (KR)

• Suh, Jeong
Pusanjin-gu, Pusan-shi (KR)
• Kim, In Woong
Daejeon-shi (KR)
• Park, Jeong Ho
Youseong-gu, Daejeon-shi (KR)
• Kim, Jeong O.
Youseong-gu, Daejeon-shi (KR)

(74) Representative:
Keib, Gérard et al
NOVAMARK TECHNOLOGIES
Anciennement Brevets Rodhain & Porte
122, Rue Edouard Vaillant
92593 Levallois Perret Cedex (FR)

(54) Method for fabricating screens and apparatus for carrying out the method

(57) A screen fabricating method capable of achieving an easy fabrication of screens and reducing the fabrication time while achieving an improvement in the resolution of patterns obtained. An apparatus for effectively carrying out the screen fabricating method is provided. The screen fabricating method includes the steps of coating a photosetting resin over a screen to be formed with a desired pattern, setting a portion of the photosetting resin corresponding to the pattern using an ultraviolet laser beam, cleaning the screen, and re-setting the photosetting resin. The apparatus includes a screen coated with a photosetting resin and adapted to have a desired pattern, an ultraviolet laser beam generating unit for generating an ultraviolet laser beam adapted to set the photosetting resin on the screen, an A/O modulator for shielding or opening a path for the ultraviolet laser beam, and a beam feeding and focusing unit for feeding the ultraviolet laser beam to the screen and focusing the fed ultraviolet laser beam on the screen.

## Description

## BACKGROUND OF THE INVENTION

Field of the Invention

The present invention relates to a method for fabricating screens and an apparatus carrying out the method, and more particularly to a screen fabricating method capable of achieving an easy fabrication of screens and reducing the fabrication time while achieving an improvement in the resolution of patterns obtained. The present invention also relates to an apparatus for effectively carrying out the screen fabricating method.

Description of the Prior Art

Fabrics are printed with desired patterns by locally supplying dyes to those fabrics. Such a printing is carried out using a rotary screen printing method or a flat screen printing method. In accordance with the rotary screen printing method, patterns are formed on fabrics in a continuous manner. In accordance with the flat screen printing method, patterns are formed on fabrics in an intermittent manner. Both the printing methods use a porous screen formed with a desired pattern. In such a porous screen, a portion of pores not to be supplied with dyes is blocked by a resin while a portion of pores to be supplied with dyes is maintained as it is. Accordingly, dyes are selectively supplied to fabrics through the open pores of the screen. In the rotary screen printing method used for a continuous printing, a cylindrical drum formed by a thin metal plate is typically used. The cylindrical drum has a plurality of pores. Methods for patterning such a rotary screen drum include a photoresist method using a photosetting film and a method using $CO_2$-laser beams.

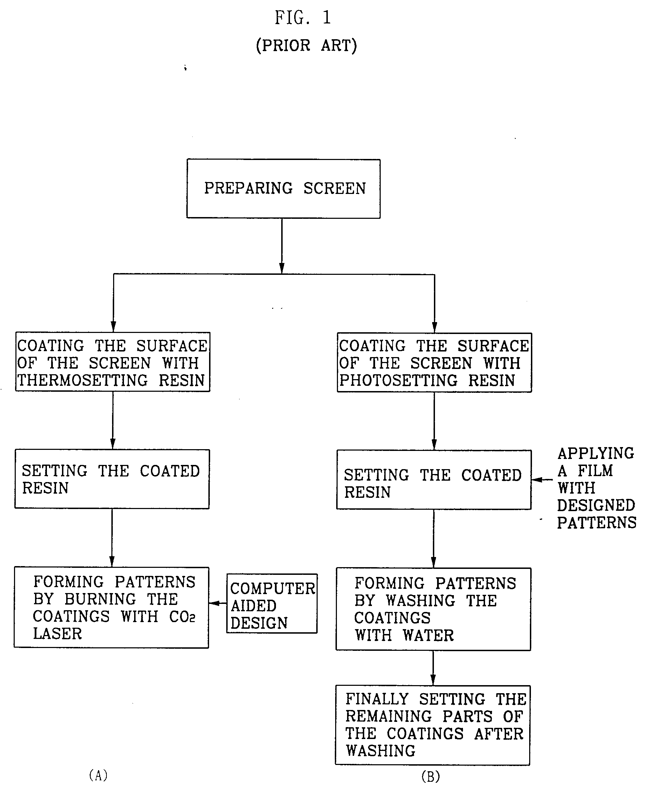

Referring to FIG. 1, processes for fabricating screens respectively using the above-mentioned rotary screen drum patterning methods are illustrated. In FIG. 1, the portion A shows a process for fabricating screens in accordance with the $CO_2$-laser beam method whereas the portion B shows a process for fabricating screens in accordance with the photoresist method. The screen fabricating method using $CO_2$-laser beams has advantages and disadvantages as compared with the screen fabricating method using photosetting films. Such advantages and disadvantages are shown in the following Table 1.

TABLE 1

Advantages and Disadvantages of Screen Fabricating Method
Using $CO_2$-Laser Beams as Compared to Screen Fabricating
Method Using Photosetting Films

| Advantage |
| --- |
| 1. Elimination of Film Fabricating Process |
| 2. Reduction in Screen Fabrication Time |

| Disadvantage |
| --- |
| 1. Increase in Installation Costs of Screen Fabricating System |
| 2. Degradation in Resolution |

In the screen fabricating method using the photoresist process, a photosetting film fabrication process is used which involves the steps of optically transferring a pattern formed using a computer-aided design (CAD) onto a film and developing the patterned film. However, this process is problematic in that it should use expensive films and an expensive film fabrication machine while requiring a lot of time for the fabrication of photosetting films.

On the other hand, the screen fabricating method using $CO_2$-laser beams has an advantage in that no film fabrication process used in the screen fabricating method using photosetting films is required because the pattern of a screen is formed using $CO_2$-laser beams. However, this method also has disadvantages in an increase in the installation costs and a degradation in the resolution of finally obtained patterns. This will be described in more detail.

In the case of using $CO_2$-laser beams, it is difficult to reduce the size of a focus formed by a convex lens used. For instance, even when a convex lens having a short focus length of 2.5 inches is used, it is difficult to obtain a focus size of $100\mu m$ or less. Such a short focus length of the lens used results in a short depth of focus. Due to such a short depth of focus, the position of the focus may be easily shifted even by small variations generated during the rotation of the rotary screen. In this case, a considerable variation in the focus size occurs. For this reason, a complex device called a "vibration damping device" should be used to fix the surface of the screen at a focused position. However, such a vibration damping device is expensive and inconvenient in use.

## SUMMARY OF THE INVENTION

The present invention has been made in view of the above-mentioned problems involved in the conventional screen fabricating methods, and an object of the invention is to provide a screen fabricating method capable of easily fabricating a screen having a pattern exhibiting a high resolution without using any film fabricating process involving an increase in the installation costs.

Another object of the invention is to provide an apparatus for efficiently carrying out the above-mentioned screen fabricating method, which apparatus is inexpensive and easy in use while being used not only in the fabrication of rotary screens, but also in the regeneration of used screens.

In accordance with one aspect, the present invention provides a method for fabricating a screen, comprising the steps of: coating a photosetting resin over a screen to be formed with a desired pattern; setting a portion of the photosetting resin corresponding to the pattern using an ultraviolet laser beam; cleaning the screen; and re-setting the photosetting resin.

Preferably, the ultraviolet laser beam for setting the photosetting resin coated over the screen may be an argon ion laser beam or a helium-cadmium laser beam.

The screen may be a rotary screen adapted to form patterns on fabrics in a continuous manner or a flat screen adapted to form patterns on fabrics in an intermittent manner.

After being used, the screen may be regenerated by burning the thermosetting resin coated on the screen using a $CO_2$-laser beam.

In accordance with another aspect, the present invention provides an apparatus for fabricating a screen, comprising: a screen coated with a photosetting resin and adapted to have a desired pattern; an ultraviolet laser beam generating unit for generating an ultraviolet laser beam adapted to set the photosetting resin on the screen; an A/O modulator for shielding or opening a path for the ultraviolet laser beam; and a beam feeding and focusing unit for feeding the ultraviolet laser beam to the screen and focusing the fed ultraviolet laser beam on the screen.

The screen fabricating apparatus includes no vibration damping device adapted to fix a surface of the screen at a focused position since the ultraviolet laser beam used has a small focus size while exhibiting a great depth of focus. Although the screen fabricating apparatus includes no vibration damping device, it is capable of obtaining a pattern having a high resolution.

The screen may be a rotary screen adapted to form patterns on fabrics in a continuous manner. In order to fabricate such a rotary screen, the screen fabricating apparatus further comprises a $CO_2$-laser beam generating unit. In this case, the ultraviolet laser beam and $CO_2$-laser beam are sequentially applied to the beam feeding and focusing unit so that both the pattern forming function and screen regenerating function are obtained.

The screen fabricating apparatus further comprises a desired number of laser beam guide mirrors arranged downstream from the $CO_2$-laser beam generating unit adapted to guide the laser beam in a desired direction.

The screen fabricating apparatus may further comprise a flat screen adapted to form patterns on fabrics in an intermittent manner. In this case, the screen fabricating apparatus further comprises a beam switching box arranged downstream from the A/O modulator in a continuous manner. The beam switching box reflects a laser beam emerging from the A/O modulator. The screen fabricating apparatus further comprises a mirror control unit adapted to control the laser beam guide mirrors in such a manner that the reflected beam is irradiated onto the flat screen. By this configuration, it is possible to selectively irradiate the laser beam onto the rotary screen or flat screen.

Where it is desired to irradiate the laser beam onto the rotary screen adapted to form patterns on fabrics in a continuous manner, the laser beam is controlled to pass through the beam switching box.

Where an ultraviolet laser beam is used in place of a $CO_2$-laser beam in accordance with the present invention, it is possible to eliminate the problems involved in the case using the $CO_2$-laser beam. This is because the ultraviolet laser beam is focused in the form of a fine point by virtue of its small focus size. The ultraviolet laser beam is also hardly influenced by vibrations generated during a high-speed rotation of the screen.

## BRIEF DESCRIPTION OF THE DRAWINGS

Other objects and aspects of the invention will become apparent from the following description of embodiments with reference to the accompanying drawings in which:

FIG. 1 is a flow chart illustrating conventional methods for fabricating rotary screens, in which a portion A thereof illustrates a screen fabricating method using $CO_2$-laser beams whereas a portion B thereof illustrates a screen fabricating method using a photoresist process;

FIG. 2 is a schematic view illustrating the relationship among wavelength, length of focus, diameter of focus and depth of focus established where an argon ion laser beam (mainly, having a wavelength of 351 nm) is used;

FIG. 3 is a flow chart illustrating sequential steps of a screen fabricating method using ultraviolet laser beams in accordance with the present invention;

FIG. 4 is a schematic view illustrating an apparatus for fabricating screens in accordance with the method of the present invention; and

FIG. 5 is a view illustrating a beam feeding and focusing unit included in the apparatus of FIG. 4.

## DESCRIPTION OF THE PREFERRED EMBODIMENTS

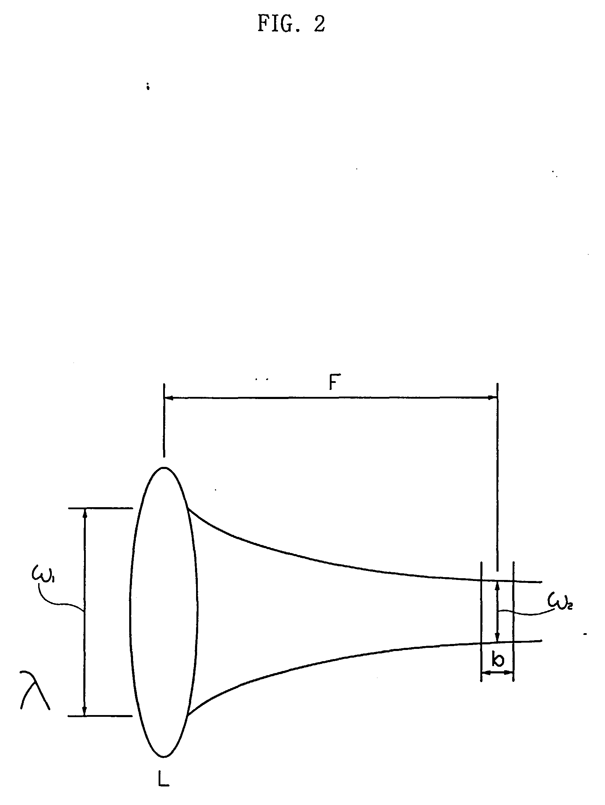

In accordance with the present invention, a screen fabricating method is provided which uses an ultraviolet laser beam to set a photosetting resin coated over a screen upon patterning the photosetting resin. FIG. 2 illustrates the relationship among wavelength, length of focus, diameter of focus and depth of focus established where an argon ion laser beam (mainly, having a wavelength of 351 nm) is used as the ultraviolet laser beam to set the photosetting resin coated over the screen. In FIG. 2, the reference character "L" represents a focusing lens, "$\lambda$" the wavelength of a laser beam used, "F" the distance of focus formed, "b" the depth of focus, "$\omega_1$" the diameter of the beam, and "$\omega_2$" the diameter of focus, respectively. "$\omega_2$" and "b" are expressed by the following equations:

$$\omega_2 = 8\lambda F/\pi\omega_1$$

$$b = (8\lambda/\pi)(F/\omega_1)^2$$

Respective data about $CO_2$-laser and ion laser beams are shown in the following Table 2:

TABLE 2

| Comparison between $CO_2$-Laser and Ion Laser Beams | | | | | |
|---|---|---|---|---|---|
| | $\lambda(\mu m)$ | F(mm) | $\omega_1$(mm) | $\omega_2(\mu m)$ | b($\mu m$) |
| $CO_2$-Laser Beam | 10.6 | 63.5 | 15 | 114 | 483 |
| | 0.351 | 63.5 | 2 | 28 | 901 |
| Ar Ion laser Beam | 0.351 | 127 | 2 | 56 | 3,605 |
| | 0.351 | 254 | 2 | 112 | 14,423 |

In order to obtain a focus diameter of 112 $\mu$m, a focusing lens having a long focus length F of 254 mm should be used in the case using the argon ion laser beam. On the other hand, a focusing lens having a short focus length F of 63.5 mm can be used to obtain a focus diameter of 112 $\mu$m in the case using the $CO_2$-laser beam. In the case using the $CO_2$-laser beam, a focus depth of 438 $\mu$m is obtained. In the case using the argon ion laser beam, a focus depth of 14,324 $\mu$m is obtained which corresponds to about 30 times the focus depth obtained in the case using the $CO_2$-laser beam. These results mean that where the argon ion laser beam is used, it is possible to form patterns having a high resolution without an influence of vibrations generated during a high-speed rotation of the screen.

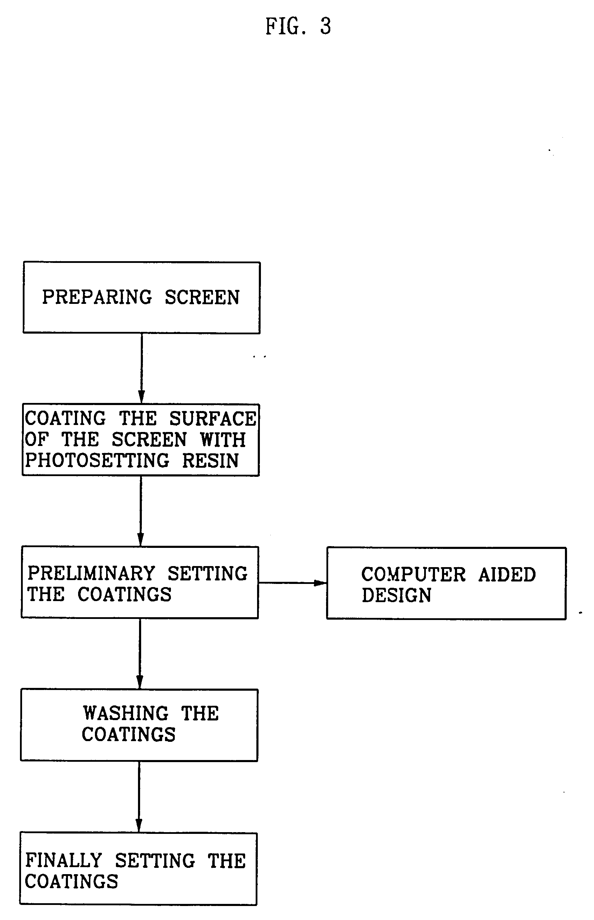

FIG. 3 is a flow chart illustrating sequential steps of the screen fabricating method using ultraviolet laser beams in accordance with the present invention. The method of the present invention is applicable to both the rotary screen and flat screen. In accordance with the method of the present invention, a photosetting resin is coated over a screen. The coated photosetting resin is selectively set using an ultraviolet laser beam at its portion corresponding to a desired pattern designed in accordance with, for example, a CAD. The screen is then subjected to a cleaning process so as to remove the set portion of the photosetting resin. In the screen, accordingly, a portion of pores not to be supplied with dyes is blocked by the resin while a portion of pores to be supplied with dyes is maintained as it is. In accordance with the kind of the resin used, the portion of the resin not set may be removed. After completing the cleaning process, the resin left on the screen is set again. Thus, the fabrication of the screen is completed. Using the fabricated screen, desired patterns can be formed on fabrics. Where the screen is required to be used no longer, its resin is burned using a $CO_2$-laser beam. Accordingly, the screen is regenerated for its future use.

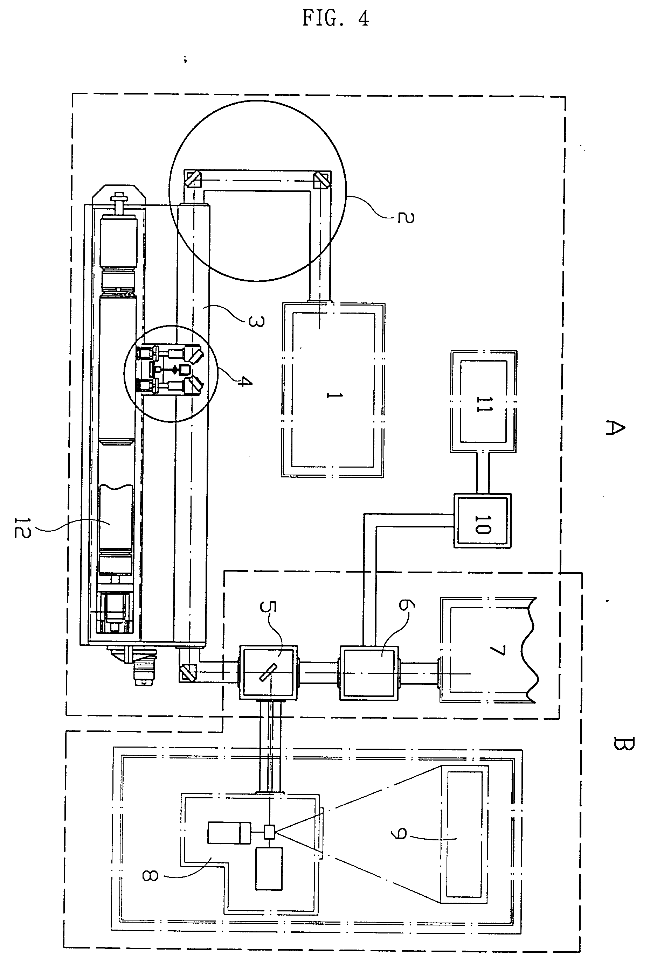

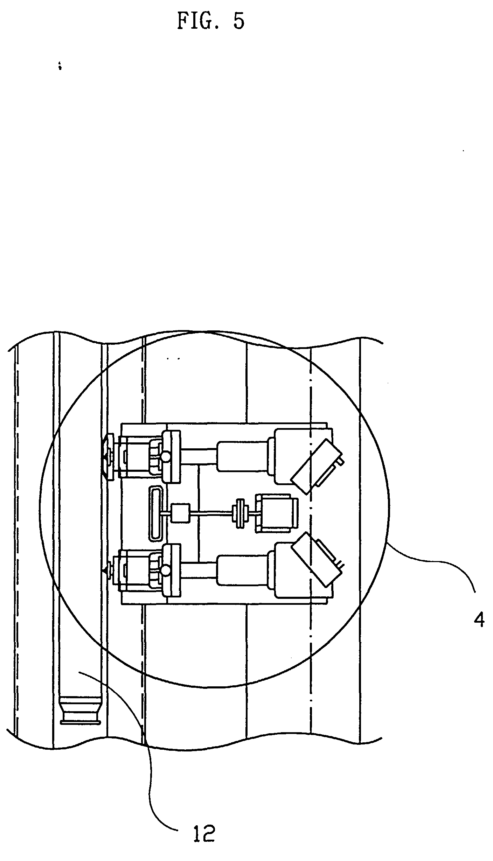

FIG. 4 illustrates an apparatus for fabricating screens in accordance with the method of the present invention. FIG. 5 illustrates a beam feeding and focusing unit included in the apparatus of FIG. 4.

Now, the configuration and operation of the screen fabricating apparatus according to the present invention will be described in detail.

In FIG. 4, the portion A shows a rotary engraving device included in the screen fabricating apparatus and adapted to fabricate rotary screens whereas the portion B shows a flat screen fabricating device included in the screen fabricating apparatus to fabricate flat screens.

First, the operation of the rotary engraving device shown in the portion A of FIG. 4 will be described in detail. A laser beam, in particular, an ultraviolet laser beam, which is generated from an argon ion laser beam generating unit 7, passes through a beam switching box 5 via an A/O modulator 6. The laser beam emerging from the beam switching box 5 enters a rotary engraving rotating unit 3. In the rotary engraving rotating unit 3, the laser beam passes through a beam feeding and focusing unit 4 so that it is focused onto the surface of a rotary screen 12 disposed in the rotary engraving rotating unit 3. The rotary screen 12, which is coated with a photosetting resin, rotates at a high speed of about 1,200 rpm. In order to form a desired pattern on the surface of the rotary screen 12, the A/O modulator 6 is controlled by a controller 11 in accordance with CAD data. In FIG. 4, the CAD data is denoted by the reference numeral "10". The controller 11 operatively connects the CAD data 10 to the rotated position of the rotary screen 12 and controls the A/O modulator 6 to open or shield the path of the laser beam in accordance with the rotated position of the rotary screen 12. Accordingly, the photosetting resin coated over the surface of the screen is selectively set to form a desired pattern. After the setting of the photosetting resin, the screen is subjected to a cleaning process and a re-setting process. Thus, the fabrication of the rotary screen is completed.

Where it is necessary to remove the resin coated on the surface of the rotary screen, thereby regenerating the screen, a $CO_2$-laser beam 1 is used. The $CO_2$-laser beam 1 is reflected by a desired number of laser beam guide mirrors 2 arranged in the rotary engraving device. The reflected beam is then fed to the surface of the screen via the beam feeding and focusing unit 4. The beam is then focused onto the surface of the screen, so that it removes the coated resin by virtue of its beam energy. Thus, the screen is regenerated for its future use.

In order to generate the $CO_2$-laser beam, the screen fabricating apparatus of the present invention includes a $CO_2$-laser beam generating unit. As the ultraviolet laser beam and $CO_2$-laser beam are sequentially applied to the beam feeding and focusing unit, both the pattern forming function and screen regenerating function are obtained.

Now, the flat screen fabricating device shown in the portion B of FIG. 4 will be described in detail. The argon ion laser beam generating unit 7 can be selectively used for the rotary engraving device and flat screen fabricating device. For the flat screen fabricating device, the laser beam generated from the argon ion laser beam generating unit 7 is reflected 90° by a mirror arranged in the beam switching box 5 after passing through the A/O modulator 6, so that it enters a mirror control unit 8. Thereafter, the laser beam is irradiated onto a flat screen 9 by the mirror control unit 8. In this case, the A/O modulator 6 and mirror control unit 8 is controlled in accordance with the CAD data 10 so that the laser beam is irradiated onto the flat screen 9 in a controlled manner, thereby selectively setting a photosetting resin coated over the flat screen 9. After the setting of the photosetting resin, the screen is subjected to a cleaning process and a re-setting process. Thus, the fabrication of the flat screen is completed.

In accordance with the present invention, the ultraviolet laser beam is selectively used for the rotary engraving device and flat screen fabricating device. Accordingly, the use rate of the laser beam increases, thereby maximizing the efficiency of the laser beam.

In particular, since the ultraviolet laser beam exhibits a small focus size and a small focus depth, the present invention is advantageous in terms of the problem associated with vibrations generated during the rotation of the rotary screen. In other words, it is possible to form patterns having a high resolution without using any additional vibration damping device for fixing the surface of the rotary screen at a focused position.

As apparent from the above description, the present invention provides a screen fabricating method which requires no film fabricating process involving an increase in the installation costs, thereby being capable of achieving an easy fabrication of screens and reducing the fabrication time while achieving an improvement in the resolution of patterns obtained. The present invention completely eliminates disadvantages involved in conventional methods using $CO_2$-laser beams.

Although the preferred embodiments of the invention have been disclosed for illustrative purposes, those skilled in the art will appreciate that various modifications, additions and substitutions are possible, without departing from the scope and spirit of the invention as disclosed in the accompanying claims.

## Claims

1. A method for fabricating a screen, comprising the steps of:

    coating a photosetting resin over a screen to be formed with a desired pattern;
    setting a portion of the photosetting resin corresponding to the pattern using an ultraviolet laser beam;
    cleaning the screen; and
    re-setting the photosetting resin.

2. The method in accordance with Claim 1, wherein the ultraviolet laser beam is an argon ion laser beam or a helium-cadmium laser beam.

3. The method in accordance with Claim 1 or 2, wherein the screen is a rotary screen adapted to form patterns on fabrics in a continuous manner or a flat screen adapted to form patterns on fabrics in an intermittent manner.

4. The method in accordance with Claim 1 or 2, wherein the screen is able to be regenerated after being used, by burning the thermosetting resin coated on the screen using a $CO_2$-laser beam.

5. An apparatus for fabricating a screen, comprising:

   a screen coated with a photosetting resin and adapted to have a desired pattern;
   an ultraviolet laser beam generating unit for generating an ultraviolet laser beam adapted to set the photosetting resin on the screen;
   an A/O modulator for shielding or opening a path for the ultraviolet laser beam; and
   a beam feeding and focusing unit for feeding the ultraviolet laser beam to the screen and focusing the fed ultraviolet laser beam on the screen.

6. The apparatus in accordance with Claim 5, wherein the ultraviolet laser beam is an argon ion laser beam or a helium-cadmium laser beam.

7. The apparatus in accordance with Claim 5 or 6, wherein the screen fabricating apparatus includes no vibration damping device adapted to fix a surface of the screen at a focused position.

8. The apparatus in accordance with Claim 5, wherein the screen is a rotary screen adapted to form patterns on fabrics in a continuous manner.

9. The apparatus in accordance with Claim 5 or 8, further comprising a $CO_2$-laser beam generating unit so that the ultraviolet laser beam and a $CO_2$-laser beam generated from the $CO_2$-laser beam generating unit are sequentially applied to the beam feeding and focusing unit, whereby both the pattern forming function and screen regenerating function are obtained.

10. The apparatus in accordance with Claim 9, further comprising a desired number of laser beam guide mirrors arranged downstream from the $CO_2$-laser beam generating unit.

11. The apparatus in accordance with Claim 5 or 6, further comprising a flat screen adapted to form patterns on fabrics in an intermittent manner.

12. The apparatus in accordance with Claim 11, further comprising:

   a beam switching box arranged downstream from the A/O modulator in a continuous manner and adapted to reflect a laser beam emerging from the A/O modulator; and
   a mirror control unit adapted to control the laser beam guide mirrors in such a manner that the reflected beam is irradiated onto the flat screen.

13. The apparatus in accordance with Claim 12, wherein the screen is a rotary screen adapted to form patterns on fabrics in a continuous manner, and the laser beam is controlled to pass through the beam switching box.

FIG. 1

(PRIOR ART)

```
                    ┌─────────────────────────┐
                    │   PREPARING  SCREEN     │
                    └─────────────────────────┘
```

| COATING THE SURFACE OF THE SCREEN WITH THERMOSETTING RESIN | COATING THE SURFACE OF THE SCREEN WITH PHOTOSETTING RESIN |
|---|---|

| SETTING THE COATED RESIN | SETTING THE COATED RESIN | APPLYING A FILM WITH DESIGNED PATTERNS |
|---|---|---|

| FORMING PATTERNS BY BURNING THE COATINGS WITH $CO_2$ LASER | COMPUTER AIDED DESIGN | FORMING PATTERNS BY WASHING THE COATINGS WITH WATER |
|---|---|---|

| | | FINALLY SETTING THE REMAINING PARTS OF THE COATINGS AFTER WASHING |
|---|---|---|

(A)                                    (B)

FIG. 2

FIG. 3

```
┌─────────────────────┐
│  PREPARING  SCREEN  │
└─────────────────────┘
           │
           ▼
┌─────────────────────┐
│COATING  THE  SURFACE│
│OF  THE  SCREEN  WITH│
│PHOTOSETTING  RESIN  │
└─────────────────────┘
           │
           ▼
┌─────────────────────┐         ┌─────────────────────┐
│PRELIMINARY  SETTING │────────▶│ COMPUTER  AIDED     │
│THE  COATINGS        │         │ DESIGN              │
└─────────────────────┘         └─────────────────────┘
           │
           ▼
┌─────────────────────┐
│   WASHING  THE      │
│   COATINGS          │
└─────────────────────┘
           │
           ▼
┌─────────────────────┐
│FINALLY  SETTING  THE│
│COATINGS             │
└─────────────────────┘
```

FIG. 4

FIG. 5

European Patent
Office

**EUROPEAN SEARCH REPORT**

Application Number

EP 97 40 2735

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 233 918 A (HALE DAVID)<br>* the whole document * | 1 | G03F7/12<br>B41C1/14 |
| X | EP 0 762 212 A (SCHABLONENTECHNIK KUFSTEIN AG)<br>* page 8, line 13 – line 14; claims *<br>* page 2, line 37 – line 42 *<br>* page 8, line 24 * | 2,3,5,6,8 | |
| X | EP 0 692 741 A (SCHABLONENTECHNIK KUFSTEIN AG)<br>* page 2, line 25 – line 35; claims * | 5 | |
| X | EP 0 593 806 A (KUFSTEIN SCHABLONENTECH GMBH)<br>* column 10, line 24 – line 42; claims * | 2,3,5,6,8 | |
| X | EP 0 423 054 A (HOPE COMPUTER CORP)<br>* abstract* | 7 | |
| X | DE 41 42 887 A (MS SERVIZI INFORMATICI)<br>* the whole document * | 5 | TECHNICAL FIELDS SEARCHED (Int.Cl.6)<br><br>G03F<br>B41C |
| A | WO 93 25387 A (ZED INSTR LTD ;ROBERTS SIMON HUGH (GB))<br>* the whole document * | 5 | |
| A | WO 89 11116 A (ANDERSEN ALLAN V)<br>* the whole document * | 5 | |

The present search report has been drawn up for all claims

| Place of search | Date of completion of the search | Examiner |
|---|---|---|
| THE HAGUE | 22 April 1998 | Rasschaert, A |

EPO FORM 1503 03.82 (P04C01)

**ANNEX TO THE EUROPEAN SEARCH REPORT
ON EUROPEAN PATENT APPLICATION NO.**                    EP 97 40 2735

This annex lists the patent family members relating to the patent documents cited in the above-mentioned European search report.
The members are as contained in the European Patent Office EDP file on
The European Patent Office is in no way liable for these particulars which are merely given for the purpose of information.

22-04-1998

| Patent document cited in search report | Publication date | Patent family member(s) | Publication date |
|---|---|---|---|
| US 5233918 A | 10-08-93 | NONE | |
| EP 0762212 A | 12-03-97 | AU 6421396 A | 13-03-97 |
| EP 0692741 A | 17-01-96 | AT 151178 T<br>CN 1119584 A<br>DE 59402310 D<br>ES 2102106 T | 15-04-97<br>03-04-96<br>07-05-97<br>16-07-97 |
| EP 0593806 A | 27-04-94 | EP 0658812 A<br>US 5384007 A<br>US 5443677 A | 21-06-95<br>24-01-95<br>22-08-95 |
| EP 0423054 A | 17-04-91 | DK 510389 A<br>AT 116180 T<br>DE 69015554 D<br>DE 69015554 T<br>JP 3171052 A | 14-04-91<br>15-01-95<br>09-02-95<br>10-08-95<br>24-07-91 |
| DE 4142887 A | 25-06-92 | IT 1246734 B<br>FR 2670922 A<br>GB 2253112 A,B<br>US 5201027 A | 26-11-94<br>26-06-92<br>26-08-92<br>06-04-93 |
| WO 9325387 A | 23-12-93 | AT 159457 T<br>AU 669721 B<br>AU 4344893 A<br>DE 69314791 D<br>EP 0644829 A<br>JP 7507734 T | 15-11-97<br>20-06-96<br>04-01-94<br>27-11-97<br>29-03-95<br>31-08-95 |
| WO 8911116 A | 16-11-89 | AU 3699689 A<br>DK 264190 A,B,<br>EP 0423150 A<br>JP 3504109 T<br>US 5580698 A | 29-11-89<br>05-11-90<br>24-04-91<br>12-09-91<br>03-12-96 |

EPO FORM P0459

For more details about this annex : see Official Journal of the European Patent Office. No. 12/82